Europäisches Patentamt

European Patent Office

Office européen des brevets

(11) Numéro de publication: **0 349 365**
**A1**

## (12) DEMANDE DE BREVET EUROPEEN

(21) Numéro de dépôt: **89401652.6**

(22) Date de dépôt: **14.06.89**

(51) Int. Cl.5: **C 04 B 35/00**
C 01 G 3/00, H 01 L 39/24

(30) Priorité: **27.06.88 FR 8808580**

(43) Date de publication de la demande:
**03.01.90 Bulletin 90/01**

(84) Etats contractants désignés:
**AT BE CH DE ES FR GB GR IT LI LU NL SE**

(71) Demandeur: **RHONE-POULENC CHIMIE**
**25, quai Paul Doumer**
**F-92408 Courbevoie Cédex (FR)**

(72) Inventeur: **Seon, Françoise**
**50, avenue de la Dame Blanche**
**F-94120 Fontenay/Sous/Bois (FR)**

(74) Mandataire: **Dubruc, Philippe et al**
**RHONE-POULENC CHIMIE Service Brevets Chimie 25,**
**quai Paul-Doumer**
**F-92408 Courbevoie Cédex (FR)**

(54) Procédé de préparation de poudres céramiques homogénes supraconductrices et produits ainsi obtenus.

(57) L'invention a trait à des matériaux supraconducteurs finement divisés essentiellement à base d' au moins une terre rare, au moins M alcalino-terreux, au moins un métal de transition et d'oxygène, et caractérisé par le fait qu' ils sont substantiellement exempts de toutes phases parasites non supraconductrices.

Elle concerne également un procédé de préparation de ces supraconducteurs par une voie sels fondus.

FIG.1

EP 0 349 365 A1

Bundesdruckerei Berlin

**Description**

## PROCEDE DE PREPARATION DE POUDRES CERAMIQUES HOMOGENES SUPRACONDUCTRICES ET PRODUITS AINSI OBTENUS

La présente invention a trait au domaine des matériaux céramiques supraconducteurs.

Plus précisement, la présente invention a pour objet la préparation de ce type de produits directement sous forme de poudres fines et homogènes, et ceci par réactions chimiques se déroulant, au moins en partie, en milieu sels fondus servant de milieu réactionnel.

On sait que, jusqu'à un passé récent, l'état supraconducteur, qui se caractérise entre autre par la disparition de toute résistance électrique dans un corps porté à très basse température, n'apparaissait dans certains matériaux qu'en dessous d'une température seuil, dite "température critique", généralement proche du zéro absolu.

Un telle contrainte a constitué à l'évidence un frein sérieux au développement sur une grande échelle de toutes les applications pratiques potentielles pouvant découler de la supraconductivité.

Or, depuis peu, des recherches ont permis de mettre en évidence de nouveaux matériaux qui présentent des propriétés supraconductrices à plus hautes températures, c'est-à-dire des températures s'étalant de 70 à 90° K, voire plus.

Ces matériaux sont pour la plupart à base de terres rares, d'alcalino-terreux, de métaux de transition et d'oxygène. Plus spécifiquement, les systèmes étudiés les plus prometteurs semblent être ceux à base d'yttrium et/ou lanthane et/ou d'erbium, de baryum et/ou de strontium et/ou de calcium, de cuivre, et/ou éventuellement d'autres métaux de transition, et d'oxygène.

Parmi les systèmes les plus étudiés, on peut citer plus particulièrement Y-Ba-Cu-O dans lequel les phases dérivant de $YBa_2Cu_3O_7$ possèdent des températures critiques voisines de 92 K.

Ils peuvent se présenter à l'état de poudres, ou bien encore à l'état de pièces denses, mais de formes simples, obtenues par frittage naturel desdites poudres ; au niveau de certaines applications pratiques, seule en effet l'utilisation des produits frittés supraconducteurs présente un intérêt réel.

Ces matériaux ouvrent des perspectives jusqu'alors inespérées dans des domaines extrêmement variés, que ce soit dans la microélectronique rapide grâce à l'annulation de la résistivité des connexions, dans la fabrication de bobines supraconductrices de stockage, dans les applications de supraconducteurs à haut champ critique pour transport par sustentation et en règle générale dans toutes les techniques qui utilisent actuellement des aimants supraconducteurs.

Mais la synthèse de ces matériaux, sous une forme ou sous une autre, pose à l'heure actuelle de nombreux problèmes.

Plus spécifiquement, la méthode de synthèse généralement décrite dans la littérature pour aboutir à ces matériaux à l'état de poudre repose sur une réaction en phase solide, à hautes températures (1000°C) entre des oxydes et/ou des sels contenant un anion volatil (par exemple le carbonate) des éléments correspondants, ces derniers composés se présentant initialement sous forme de poudres.

Toutefois, un tel procédé présente plusieurs inconvénients sérieux.

D'une part, il est d'un contrôle délicat car basé sur des réactions de diffusion à la fois lentes et difficiles entre solides cristallisés, et il en résulte généralement la formation de phases intermédiaires parasites conduisant à des inhomogénéités au sein du matériau. Ces inhomogénéités, non supraconductrices, modifient la composition de la phase majoritaire et abaissent en conséquence la valeur du courant critique admissible ou peuvent même rendre la céramique elle-même non supraconductrice.

D'autre part, il nécessite la mise en oeuvre de températures de réaction élevées.

En outre, les risques d'introduire des impuretés néfastes lors de l'étape de broyage ultérieure qu'il est généralement nécessaire de mettre en oeuvre après calcination, peuvent être gênants.

Enfin, ce procédé conduit à des poudres dont l'aptitude à la mise en forme et au frittage peut paraitre insuffisante, notamment en ce qui concerne les densités à cru susceptibles d'être obtenues et les densités finales mesurées après frittage. Ce problème de qualité peut être notamment relié à la morphologie non contrôlée des poudres de départ.

La présente invention a pour but de proposer un procédé de préparation de céramiques supraconductrices obviant aux inconvénients inhérents à la mise en oeuvre des procédés de l'art antérieur et qui permette, par des moyens simples, efficaces, économiques et de mise en oeuvre aisée, d'aboutir de manière fiable et reproductible auxdites céramiques supraconductrices directement sous forme de poudres fines et homogènes, et présentant de bonnes aptitudes au frittage.

On a maintenant trouvé que ce but, et d'autres, peuvent être atteints au moyen de la présente invention qui concerne en effet un procédé de préparation d'un matériau supraconducteur à l'état finement divisé essentiellement à base d'au moins un élément terre rare, d'au moins un élément alcalino-terreux, d'au moins un élément métal de transition et d'oxygène et qui est caractérisé par le fait qu'il consiste à traiter thermiquement le produit de réaction, obtenu dans un bain de sels fondus, entre un composé dudit élément terre-rare, un composé dudit élément alcalino-terreux, et un composé dudit élément métal de transition, les proportions entre lesdits éléments correspondant sensiblement à la stoëchiométrie de la composition supraconductrice désirée.

Dans l'exposé qui suit de la présente invention, on entend par terre rare d'une part tout élément du Tableau Périodique dont le numéro atomique est compris, inclusivement, entre 57 et 71, et d'autre part l'yttrium et le scandium qui, tous deux, sont assimilés ici par convention à une terre rare.

D'autre part, on appelera ci-après composés précurseurs, les espèces organiques et/ou inorganiques sous la forme desquelles les éléments chimiques, (en dehors éventuellement de l'oxygène), destinés à constituer la poudre supraconductrice finale peuvent être introduits dans le milieu réactionnel.

Selon l'invention, ces composés précurseurs peuvent être soit tous introduits sous forme de réactifs dans le milieu fondu réactionnel, soit en partie intégrés comme constituants à part entière dudit milieu fondu réactionnel.

Les terres rares plus particulièrement préférées pour la mise en oeuvre du procédé-selon l'invention sont l'yttrium et le lanthane.

D'autre part, les alcalino-terreux utilisables dans le présent procédé sont principalement le calcium, le baryum et le strontium.

Enfin, concernant les métaux de transition, on opèrera de préférence avec le cuivre, mais tout autre métal de transition peut éventuellement convenir.

Le choix des éléments au sein des familles ci-dessus se fera bien entendu en fonction de la nature et de la composition de la poudre supraconductrice que l'on désire obtenir.

Le procédé selon l'invention s'applique particulièrement bien à la fabrication des systèmes supraconducteurs du type Y-Ba-Cu-O ; ces systèmes ont été étudiés notamment dans un article paru dans le Journal of American Chemical Society, 1987, 109, 2528-2530.

Selon l'invention, tous les éléments chimiques requis pour l'obtention de la composition supraconductrice désirée (à l'exception éventuellement de l'oxygène) sont introduits dans le milieu réactionnel sous la forme de composés précurseurs, organiques ou inorganiques.

Concernant les composés précurseurs de l'élément terre rare, on préfère éviter l'emploi d'oxydes ou d'hydroxydes ; par contre, conviennent tout à fait pour la présente invention les sels organiques ou inorganiques de terres rares.

De préférence, on utilise des sels organiques.

Parmi lesdits sels organiques, on peut citer plus particulièrement les sels d'acides aliphatiques saturés comme par exemples les formiates, les acétates, les propionates, les citrates et les oxalates; les oxalates conviennent particulièrement bien.

Parmi les sels inorganiques, on peut citer les halogénures (chlorures, bromures, iodures et fluorures), les nitrates, les sulfates et les carbonates ; les carbonates conviennent particulièrement bien.

Concernant les composés précurseurs de l'élément alcalino-terreux, on préfère éviter l'emploi de composés inorganiques du type nitrate ou halogénure. Par contre, à titre de composés précurseurs inorganiques convenant tout à fait pour la mise en oeuvre du procédé selon l'invention, on peut citer les oxydes, les hydroxydes, les sulfates et les carbonates. L'utilisation de précurseurs organiques, tels que ceux notamment définis pour les précurseurs de l'élément terre rare, est également possible, mais selon un mode particulièrement préféré de mise en oeuvre du procédé selon l'invention, on utilise pour l'élément alcalino-terreux un précurseur de type inorganique tel que définis ci-dessus, et encore plus préférentiellement un carbonate.

Concernant enfin les composés précurseurs du métal de transition, on préfère, comme dans le cas des précurseurs de l'élément alcalino-terreux, éviter l'emploi de composés inorganiques du type nitrate ou halogénure. Peuvent par contre convenir des précurseurs inorganiques du type oxyde, hydroxyde, sulfate et carbonate. D'autre part, l'utilisation de précurseurs organiques, tels que ceux notamment définis ci-avant pour les précurseurs de l'élément terre rare, n'est pas exclue ; néanmoins, on préfère utiliser pour le métal de transition un précurseur de type inorganique tel que définis ci-dessus, et encore plus préférentiellement un oxyde ou un hydroxyde.

Le choix de la nature du bain de sels fondus qui forme le milieu réactionnel, est d'une manière générale gouverné par les deux exigences pratiques suivantes: les produits réactifs doivent tout d'abord présenter une certaine solubilité dans ce bain ; et d'autre part, le produit de réaction désiré doit y être peu soluble.

On aura bien entendu également intérêt à travailler avec des compositions de bain qui présentent des points de fusion les plus bas possible, ceci d'une part pour empêcher une trop grande consommation d'énergie et d'autre part pour éviter tout problème technologique, de corrosion notamment ; à cet effet, il peut être avantageux de travailler avec des compositions eutectiques.

Les bains de sels fondus utilisables dans la présente invention sont principalement ceux constitués par des nitrates d'alcalins ou des nitrates d'alcalino-terreux, ou bien encore par des mélanges de ceux-ci ; de préférence, on utilise des nitrates d'alcalins, et plus particulièrement du nitrate de sodium.

La température à laquelle est conduite la réaction désirée est comprise entre 100° C et 600° C, de préférence comprise entre 350° C et 500°C.

La réaction est de préférence opérée sous une atmosphère inerte telle que d'argon.

Une température comprise dans ces fourchettes est. alors suffisamment basse pour limiter les consommations d'énergie et les problèmes technologiques susmentionnés, mais aussi suffisamment élevée pour que les cinétiques des réactions mises en jeu dans le présent procédé soient rapides et donc compatibles avec une bonne marche industrielle.

Les quantités de précurseurs réactifs nécessaires à mettre en oeuvre dans le présent procédé sont ajustées classiquement en fonction de la stoechiométrie désirée dans le produit supraconducteur final, celle-ci devant naturellement correspondre à l'obtention des propriétés supraconductrices

Dans un mode pratique de mise en oeuvre du procédé selon l'invention, on prépare tout d'abord à froid, et à sec, un mélange intime constitué des composés précurseurs et des composés solvatants précédemment définis, puis on porte ce mélange à une température correspondant à l'obtention d'un état fondu, et on maintient le milieu réactionnel à cette température, de préférence sous une forte agitation mécanique ou autre, ceci jusqu'à réaction complète des composés précurseurs entre eux.

Le produit formé et précipité en cours de réaction (avec un très bon rendement, puisque pouvant être supérieur à 90 % en poids) étant solide dans les zones de température précitées, il peut être séparé facilement du milieu réactionnel.

Ainsi, après réaction, le produit précipité peut être séparé du bain par tout moyen connu en soi, notamment par filtration, ce par quoi l'on obtient d'une part le produit de réaction désiré extrait sous forme de poudre et d'autre part un mélange de sels fondus dont on peut réajuster la composition en cours de réaction par rajout de réactifs de manière à ce que le procédé fonctionne de manière continue.

Bien entendu, on peut également procéder de manière discontinue, c'est à dire attendre que les composés précurseurs introduits en une seule fois aient réagi puis, à l'issue de la réaction, refroidir la masse réactionnelle et enfin séparer le produit de réaction de sa matrice de sels, notamment par désintégration de celle-ci par un lavage avec une eau pure ou légèrement acidifiée.

Le produit de réaction recueilli par l'une ou l'autre voie (continue ou discontinue) se présente sous la forme d'une poudre très homogène chimiquement et morphologiquement, et qu'il est possible de purifier encore par simple lavage à l'eau pure ou acidifiée, suivi d'un séchage.

Le produit ainsi obtenu subit alors un traitement thermique.

Ce traitement thermique, qui constitue donc la deuxième étape du procédé selon l'invention, a pour but de générer la phase supraconductrice désirée.

La température à laquelle est conduit le traitement thermique est généralement comprise entre 700°C et 1000°C, et de préférence comprise entre 850°C et 950°C.

La durée de ce traitement thermique peut varier entre 30 mn et 24 heures, et de préférence entre 1 heure et 10 heures

Il est généralement conduit sous atmosphère d'air, ou sous un mélange air/oxygène, mais de préférence sous air.

A l'issue de ce traitement thermique, on récupère une poudre dont la taille moyenne des particules, mesurée au microscope électronique à balayage, est comprise entre 10 μ et 50 μ.

Il peut être éventuellement souhaitable de procéder à une étape finale de broyage pour amener la poudre à une granulométrie rigoureuse, de manière notamment à pouvoir conduire un bon frittage.

Ces poudres sont parfaitement pures et homogènes, exactement ajustées à la stoechiométrie de la composition supraconductrice désirée; aucune phase parasite n'est alors observable (produit monophasique).

Ces poudres présentent le phénomène de supraconductivité que l'on peut observer par l'apparition d'un diamagnétisme dû à l'effet Meisner.

Les poudres supraconductrices fines et homogènes issues du procédé selon l'invention présentent en outre une aptitude remarquable à pouvoir donner, après mise en oeuvre de procédés classiques de frittage, des matériaux frittés possédant de très bonnes propriétés supraconductrices, parfaitement homogènes, et dont la densité finale est supérieure à 95 % de la densité théorique du matériau considéré.

Des exemples non limitatifs illustrant l'invention dans le cadre particulier de la préparation de poudres supraconductrices de formule $YBa_2Cu_3O_{7-x}$ ($0 < x \leqq 0,2$) vont maintenant être donnés.

EXEMPLE 1

On réalise un mélange, à froid et à sec, comprenant :
- 300 g de nitrate de sodium $NaNO_3$ (qui servira, une fois fondu, de milieu solvant)
- 79 g de carbonate de baryum $BaCO_3$,
- 62,2 g d'oxalate d'yttrium $Y_2(C_2O_4)_3$ $10H_2O$,
- 47,8 g d'oxyde de cuivre $CuO$.

Ce mélange est ensuite porté à une température de 420°C à laquelle il est maintenu, sous une forte agitation mécanique (rotor à pâle : 900 tr/mn), pendant une durée supérieure ou égale à 15 minutes.

Durant cette période, il y a réaction entre les composés précurseurs du supraconducteur désiré.

Après décantation du solide formé, puis lavage à l'eau et séchage à 50°C, on récupère environ 126 g d'un produit très homogène ; les eaux de lavage ne contiennent ni yttrium, ni cuivre, ni baryum.

Le produit ainsi formé (avec un rendement voisin de 95 % en poids) est ensuite calciné sous air, à 925°C, et pendant 5 heures.

On obtient alors 120 g (rendement en poids : 90 %) d'une poudre de granulométrie moyenne comprise entre 20 μ et 50 μ, et dont l'analyse du spectre X et l'analyse chimique montrent qu'elle correspond au composé de formule $YBa_{2,02}$ $Cu_{2,95}$ $O_{6,8}$ cristallisé sous sa forme orthorhombique.

Aucune phase parasite n'est détectable. Cette poudre présente des propriétés supraconductrices observables par l'apparition d'un diamagnétisme dû à l'effet MEISNER. En caractérisation magnétique, le produit présente 100 % de volume supraconducteur à 88°K.

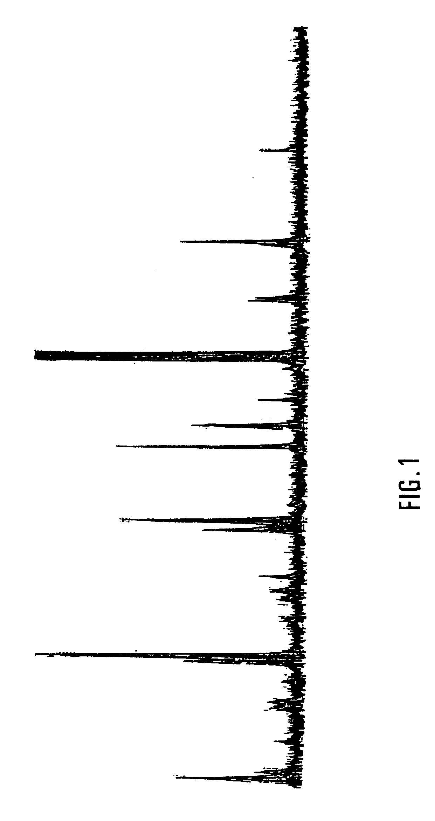

Le spectre X de cette poudre est donné à la figure 1.

Exemple 2

On répète l'exemple 1 en changeant simplement la nature du mélange initial :
- nitrate de sodium : 300 g
- carbonate d'yttrium $Y_2(CO_3)_3$ - 3,4 $H_2O$ : 41,8 g
- carbonate de baryum $BaCO_3$ : 78,9 g
- oxyde de cuivre $CuO$ : 47,7 g.

Le mélange est porté à 480°C pour obtenir l'état fondu.

La masse de produit formé avant calcination est de 126,5 g.

La masse de produit formé après calcination est de 110,4 g.

Comme dans l'exemple 1, le produit obtenu après calcination correspond à une poudre supraconductrice de formule $Y Ba_{2,02} Cu_{2,95} O_{6,8}$ cristallisée sous une forme orthorhombique.

Aucune phase parasite n'est détectable.

Exemple comparatif 1

Cet exemple a pour but de comparer le procédé selon l'invention à un procédé classique de chamottage de l'art antérieur.

6,2 g d'oxalate d'yttrium sont traités à 420°C pendant 3 heures sous air pour donner de l'oxycarbonate d'yttrium ; ce produit est alors mélangé à sec à 7,9 g de carbonate de baryum et 4,8 g d'oxyde de cuivre.

Ce mélange est alors broyé puis calciné sous air, pendant 4 heures, à 925°C.

L'analyse par diffraction X et l'analyse chimique du produit obtenu montre que ce dernier est constitué :
- d'une phase de formule $YBa_2 Cu_3 O_{6,8}$ cristallisée sous forme quadratique
- de phases parasites identifiées aux composés $BaCuO_2$ et $Y_2Cu_2O_5$
- de carbonate de baryum et d'oxyde du cuivre non réagis.

Exemple comparatif 2

Cet exemple a pour but de comparer le procédé selon l'invention à une voie en phase liquide aqueuse.

30 g de nitrate de sodium sont dissous dans 100 cm$^3$ d'eau à 80°C. On ajoute à cette solution 6,2 g d'oxalate d'yttrium, 7,89 g de carbonate de baryum et 4,77 g d'oxyde de cuivre.

Le mélange est alors agité vigoureusement pendant 4 heures puis filtré. Le solide récupéré est lavé à l'eau puis séché. Le produit obtenu est alors calciné sous air, pendant 5 heures, à 925°C.

L'analyse du spectre X et l'analyse chimique du produit calciné indiquent que ce dernier est constitué :
- d'une phase répondant à la formule $YBa_2 Cu_3 O_{6,8}$, cristallisée sous une forme orthorombique
- une phase parasite identifiée au composé $Y_2BaCuO_5$
- de carbonate de baryum et d'oxyde de cuivre non réagis.

**Revendications**

1/ Matériau supraconducteur finement divisé essentiellement à base d'au moins un élément terre rare, d'au moins un élément alcalino-terreux, d'au moins un élément métal de transition et d'oxygène, caractérisé par le fait qu'il est substantiellement exempt de phases parasites non supraconductrices.

2/ Matériau selon la revendication 1, caractérisé en ce qu'il répond essentiellement à la formule globale $Y Ba_2 Cu_3 O_{7-x}$ dans laquelle $O < x \leq 0,2$.

3/ Matériau selon la revendication 2 caractérisé en ce qu'il présente un volume supraconducteur de 100 % à 88 K.

4/ Matériau selon l'une quelconque des revendications 2 et 3 caractérisé en ce qu'il présente un spectre de diffraction par rayons X tel que représenté à la figure 1.

5/ Procédé de préparation d'un matériau supraconducteur à l'état finement divisé, essentiellement à base d'au moins un élément terre rare, d'au moins un élément alcalino-terreux, d'au moins un élément métal de transition et d'oxygène, caractérisé par le fait qu'il consiste à traiter thermiquement le produit de réaction, obtenu dans un bain de sels fondus, entre un composé dudit élément terre rare, un composé dudit élément alcalino-terreux et un composé dudit élément métal de transition, les proportions entre lesdits éléments correspondant sensiblement à la stoëchiométrie de la composition supraconductrice désirée.

6/ Procédé selon la revendication 5 caractérisé en ce que le composé dudit élément terre rare est choisi parmi un sel organique ou inorganique.

7/ Procédé selon la revendication 6 caractérisé en ce que l'on utilise un sel organique.

8/ Procédé selon la revendication 7 caractérisé en ce que ledit sel organique est un sel d'acide aliphatique saturé.

9/ Procédé selon la revendication 8 caractérisé en ce que l'on utilise un sel choisi parmi les formiates, les acétates, les proprionates, les citrates et les oxalates.

10/Procédé selon la revendication 9 caractérisé en ce que l'on utilise des oxalates.

11/Procédé selon la revendication 6 caractérisé en ce que l'on utilise un sel inorganique choisi parmi les halogénures, et notamment chlorures, bromures, iodures et fluorures, les nitrates, les sulfates et les carbonates.

12/Procédé selon la revendication 11 caractérisé en ce que l'on utilise des carbonates.

13/Procédé selon l'une quelconque des revendications 5 à 12 caractérisé en ce que le composé dudit élément alcalino-terreux est un composé inorganique.

14/Procédé selon la revendication 13 caractérisé en ce que l'on utilise un composé inorganique choisi parmi les oxydes, les hydroxydes, les sulfates et les carbonates.

15/Procédé selon la revendication 14 caractérisé en ce que l'on utilise des carbonates.

16/Procédé selon l'une quelconque des revendications 5 à 12 caractérisé en ce que le composé dudit élément alcalino-terreux est un sel organique.

17/Procédé selon la revendication 16 caractérisé en ce que ledit sel organique est un sel d'acide aliphatique saturé choisi notamment parmi les formiates, les acétates, les propionates, les citrates et les oxalates.

18/Procédé selon l'une quelconque des revendications 5 à 17 caractérisé en ce que le composé dudit élément métal de transition est un composé inorganique.

19/Procédé selon la revendication 18 caractérisé en ce que l'on utilise un composé inorganique choisi parmi les oxydes, les hydroxydes, les sulfates et les carbonates.

20/Procédé selon la revendication 19 caractérisé en ce que l'on utilise des oxydes ou des hydroxydes.

21/Procédé selon l'une quelconque des revendications 5 à 17 caractérisé en ce que le composé de l'élément métal de transition est un sel organique.

22/Procédé selon la revendication 21 caractérisé en ce que ledit sel organique est un sel d'acide aliphatique saturé choisi notamment parmi les formiates, les acétates, les propionates, les citrates et les oxalates.

23/Procédé selon l'une quelconque des revendications 5 à 22 caractérisé en ce que ledit bain de sels fondus est constitué par des nitrates d'alcalins et/ou d'alcalino-terreux.

24/Procédé selon la revendication 23 caractérisé en ce que l'on utilise des nitrates d'alcalins.

25/Procédé selon la revendication 24 caractérisé en ce que l'on utilise du nitrate de sodium.

26/Procédé selon l'une quelconque des revendications 5 à 25 caractérisé en ce que la température dans ledit bain de sels fondus est comprise entre 100 et 600°C.

27/Procédé selon la revendication 26 caractérisé en ce que ladite température est comprise entre 350° et 500°C.

28/Procédé selon l'une quelconque des revendications 5 à 27 caractérisé en ce que la réaction dans ledit bain de sels fondus est opérée sous une atmosphère inerte, telle que d'argon.

29/Procédé selon l'une quelconque des revendications 5 à 28, caractérisé en ce que le produit de réaction est traité thermiquement à une température comprise entre 700 et 1000°C, de préférence comprise entre 850°C et 950°C.

30/Procédé selon la revendication 29 caractérisé en ce que ledit traitement thermique varie entre 30 minutes et 24 heures, de préférence entre 1 et 10 heures.

31/Procédé selon l'une des revendications 29 et 30 caractérisé en ce que l'on opère sous air ou sous un mélange air/oxygène.

32/Utilisation d'un procédé tel que défini à l'une quelconque des revendications 5 à 31 pour la préparation d'un supraconducteur essentiellement à base d'au moins une terre rare choisie parmi l'yttrium et le lanthane, d'au moins un alcalino-terreux choisi parmi le strontium et le baryum, de cuivre et d'oxygène.

33/Utilisation selon la revendication 32 pour la préparation d'un supraconducteur de formule $Y Ba_2 Cu_3 O_{7-x}$ dans laquelle $O < x \leq 0,2$.

FIG. 1

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| X | JOURNAL OF CRYSTAL GROWTH, vol. 85, 1987, pages 599-601, Elsevier Science Publishers B.V. (North-Holland Physics Publishing Division), Amsterdam, NL; T. SHISHIDO et al.: "Crystal growth of a new orthorhombic ErBa(Cu.Pt)04 material: Crystal chemistry and characterization" * Page 599 * | 1,5,6, 13,14, 18-20, 28-33 | C 04 B 35/00<br>C 01 G 3/00<br>H 01 L 39/24 |
| A | IDEM | 2-4,7- 12,15- 17,21- 27 | |
| | --- | | |
| X | APPL. PHYS. LETT., vol. 51, no. 22, 30 novembre 1987, pages 1854-1858, American Institute of Physics; A.M. HERMANN et al: "Melt-processible rare earth-Ba-Cu-O superconductors based on molten Ba-Cu oxides" * Page 1854 * | 1-6,13- 15,18- 20,28- 33 | |
| | --- | | DOMAINES TECHNIQUES RECHERCHES (Int. Cl.5) |
| A | IDEM | 7-12,16 ,17,21- 27 | C 04 B<br>C 01 G<br>H 01 L |
| | ----- | | |

Le présent rapport a été établi pour toutes les revendications

| Lieu de la recherche | Date d'achèvement de la recherche | Examinateur |
|---|---|---|
| LA HAYE | 19-09-1989 | LUETHE H. |